# EUROPEAN PATENT APPLICATION

(11) **EP 4 718 987 A1**
(43) Date of publication of application: **01.04.2026**
(21) Application number: 25181580.9
(22) Date of filing: 09.06.2025
(51) Int. Cl.: H10D 64/23, H10D 30/00, H10D 84/01, H10D 84/83

(54) **SEMICONDUCTOR DEVICE INCLUDING INSULATING LAYERS**

(30) Priority: 27.09.2024 KR 20240131612
(71) Applicant: Samsung Electronics Co., Ltd., Suwon-si, Gyeonggi-do 16677 (KR)
(72) Inventor: HWANG, Junsun, 16677 Suwon-si (KR); YOU, Ra, 16677 Suwon-si (KR); KIM, Gukhee, 16677 Suwon-si (KR); MOON, Yuji, 16677 Suwon-si (KR); SHIN, Jeongwoong, 16677 Suwon-si (KR); LEE, Hyeryeong, 16677 Suwon-si (KR); HA, Seungseok, 16677 Suwon-si (KR)
(74) Representative: Marks & Clerk LLP

(57) **Abstract**

A semiconductor device includes a substrate, a substrate insulating layer, a first isolation region, gate electrodes, a plurality of channel layers, source/drain regions, a backside contact plug, and a backside isolation region. The substrate includes a first region and a second region. The substrate insulating layer is disposed on a lower surface of the substrate. The first isolation region passes through the substrate and extends towards the substrate insulating layer. The gate electrodes are disposed on an upper surface of the substrate. The plurality of channel layers are surrounded by the gate electrodes. The source/drain regions are disposed at opposite sides of the gate electrodes, and are connected to the plurality of channel layers. The backside contact plug is connected to the source/drain regions. The backside isolation region passes through the substrate and the substrate insulating layer, and the backside isolation region separates the substrate.

## Description

### TECHNICAL FIELD

The present inventive concept relates to a semiconductor device, more specifically, to the semiconductor device including insulating layers.

### DISCUSSION OF THE RELATED ART

As the demand for high performance, high speed, and/or multifunctionalization of semiconductor devices increases, a level of integration of semiconductor devices has increased. In accordance with the trend for a high degree of integration of semiconductor devices, semiconductor devices, having a backside power delivery network (BSPDN) structure, where a power rail is disposed on a back of the semiconductor wafer, have been developed. To address limitations in operating performance due to a reduced size of planar metal oxide semiconductor field-effect transistors (MOSFETs), semiconductor devices with three-dimensional channels, where the transistors are built vertically, have been developed.

### SUMMARY

An aspect of the present inventive concept provides a semiconductor device having improved electrical properties.

According to an aspect of the present inventive concept, there is provided a semiconductor device including a substrate, a substrate insulating layer, a first isolation region, gate electrodes, a plurality of channel layers, source/drain regions, a backside contact plug, and a backside isolation region. The substrate includes a first region and a second region spaced apart from each other along a first direction. The substrate includes an upper surface and a lower surface. The substrate insulating layer is disposed on the lower surface of the substrate. The first isolation region passes through the substrate between the first region and the second region, and the first isolation region extends towards the substrate insulating layer. The gate electrodes are disposed in the first region and the second region, on the upper surface of the substrate. The plurality of channel layers are spaced apart from each other along a second direction, which is perpendicular to the upper surface of the substrate, and surrounded by the gate electrodes, wherein the plurality of channel layers are disposed on the first and second regions. The source/drain regions are disposed at opposite sides of the gate electrodes, wherein the source/drain regions are connected to the plurality of channel layers. The backside contact plug extends along the second direction from a lower surface of the substrate insulating layer to at least one of the source/drain regions, wherein the backside contact plug is connected to the source/drain regions. The backside isolation region passes through the substrate and the substrate insulating layer, and the backside isolation region separates the substrate.

The first isolation region may extend through the substrate insulating layer (e.g. in the second direction). The backside contact plug may be connected to the at least one of the source/drain regions. The gate electrodes may each extend in the first direction. Source/drain regions may be located on opposite sides of each gate electrode in a third direction, which is perpendicular to the first and second directions. The first direction may be parallel to the upper surface of the semiconductor substrate 101.

According to another aspect of the present inventive concept, there is provided a semiconductor device including a semiconductor substrate, a substrate insulating layer, gate electrodes, a plurality of channel layers, source/drain regions, and a backside contact plug. The semiconductor substrate has an upper surface and a lower surface. The substrate insulating layer is disposed on the lower surface of the semiconductor substrate. The gate electrodes are disposed on the upper surface of the semiconductor substrate and extending along a first direction, and the gate electrodes are spaced apart from each other. The plurality of channel layers are spaced apart from each other along a second direction, which is perpendicular to the upper surface of the semiconductor substrate, and the plurality of channel layers are surrounded by the gate electrodes disposed on the upper surface of the semiconductor substrate. The source/drain regions are disposed at opposite sides of the gate electrodes, and the source/drain regions include first and second source/drain regions spaced apart from each other. The backside contact plug extends along the second direction from a lower surface of the substrate insulating layer, and the backside contact plug recesses at least one of the first and second source/drain regions. A thickness of the semiconductor substrate is equal to or less than a thickness of the substrate insulating layer.

According to another aspect of the present inventive concept, there is provided a semiconductor device including a semiconductor substrate, a substrate insulating layer, gate electrodes, source/drain regions, an upper insulating layer, a front contact plug, a backside contact plug, a backside power structure, and a backside isolation region. The semiconductor substrate has an upper surface and a lower surface. The substrate insulating layer is disposed on the lower surface of the semiconductor substrate. The gate electrodes are disposed on the upper surface of the semiconductor substrate and extend along a first direction, and the gate electrodes are spaced apart from each other. The source/drain regions are disposed at opposite sides of the gate electrodes, and the source/drain regions include first and second source/drain regions spaced apart from each other. The upper insulating layer is disposed on the source/drain regions. The front contact plug passes through the upper insulating layer, and the front contact plug is connected to at least one of the first and second source/drain regions. The backside contact plug extends along a second direction, which is perpendicular to an upper surface of the substrate, from a lower surface of the substrate insulating layer, and the backside contact plug is connected to at least one of the first and second source/drain regions. The backside power structure is connected to the backside contact plug and transfer power. The backside isolation region passes through the semiconductor substrate and the substrate insulating layer. The backside isolation region separates the semiconductor substrate. Lower surface of the backside isolation region, a lower surface of the backside contact plug, and the lower surface of the substrate insulating layer are coplanar with each other.

According to an aspect of the present inventive concept, there is provided a method of manufacturing a semiconductor device including providing a substrate, disposing a substrate insulating layer on the substrate, forming a first isolation region, gate electrodes, a plurality of channel layers, source/drain regions, a backside contact plug, and a backside isolation region on the substrate. The substrate insulating layer is disposed on a lower surface of the substrate after the semiconductor substrate is partially and selectively etched. After the portion of the semiconductor substrate is selectively etched, the insulating layer is deposited. Then, the thinning process is performed to planarize surfaces. Accordingly, a lower surface of the substrate insulating layer becomes coplanar with lower surfaces the backside contact plugs, backside isolation region, first isolation region, and second isolation layer.

At least some of the above and other features of the invention are set out in the claims.

### BRIEF DESCRIPTION OF DRAWINGS

The above and other aspects and features of the present inventive concept will be more clearly understood from the following detailed description, taken in conjunction with the accompanying drawings, in which:
FIG. 1 is a plan view of a semiconductor device according to example embodiments of the present inventive concept;
FIG. 2 is a cross-sectional view of a semiconductor device according to example embodiments of the present inventive concept;
FIGS. 3, 4, 5, and 6 are cross-sectional views of a semiconductor device according to example embodiments of the present inventive concept; and
FIGS. 7A, 7B, 7C, 7D, 7E, 7F, 7G, 7H, and 7I are diagrams illustrating sequential processes in a method of manufacturing a semiconductor device according to example embodiments of the present inventive concept.

### DETAILED DESCRIPTION

Hereinafter, preferred example embodiments of the present inventive concept will be described with reference to the accompanying drawings. As used herein, the terms such as "upper," "upper portion," "upper surface," "above," "lower," "lower portion," "lower surface," "below," and "side surface" are based on the drawings, and may vary depending on a direction in which a component is actually arranged. It will be appreciated that directions and positions are defined relative to the structure of the device, and therefore do not necessarily limit the orientation of the device in use. For instance, a vertical direction may be defined perpendicular to the upper surface of a substrate (e.g. running in a direction from a lower to an upper surface of the substrate). "Upper" features of a component may be located "above" (e.g. further along the vertical direction than) "lower" features of the component. Certain components that are disposed "on" other components may be disposed directly on (e.g. in contact with) the other components, or indirectly on the other components (e.g. there may be one or more intervening components). As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Embodiments of the present inventive concept relate to a semiconductor device including insulating layers.

According to embodiments of the present inventive concept, the insulating layers may be formed on the semiconductor substrate after the semiconductor substrate is partially etched.

According to embodiments of the present inventive concept, a thinning process may be performed to planarize surfaces. Accordingly, a lower surface of the substrate insulating layer may be coplanar with lower surfaces of other vertical structures in the semiconductor device, such as backside contact plugs, backside isolation regions, first isolation regions, and second isolation regions.

Existing methods include removing portions of the semiconductor substrate to make space for other components, such as backside contact structures. This method presents challenges due to the difficulty of etching silicon (Si), which is included in the semiconductor substrate, with the precision to remove specific portions. When the etching process is not uniform or precise, the resulting surface might not be smooth or well-controlled, making it difficult to dispose vertical structures on the semiconductor substrate. As a result, weak spots caused by improper etching may lead to dicing defects, such as cracks or chips, during the subsequent wafer separation process.

Existing methods also include where the entire semiconductor substrate is removed, and the insulating layer is formed. However, the removal of semiconductor substrate may damage or disrupt the source/drain regions, which are critical parts of a transistor. Moreover, the insulating layer that replaces the semiconductor substrate might not provide the same level of thermal conductivity as the original semiconductor substrate, and the heat dissipation issues may rise.

Embodiments of the present inventive concept address these challenges by selectively etching a portion of the semiconductor substrate, depositing the insulating layer, and then making the surfaces coplanar. The embodiments of the present inventive concept avoid dicing defects, avoid damage to source/drain regions and address heat dissipation concerns by leaving a portion of the semiconductor substrate intact for heat management.

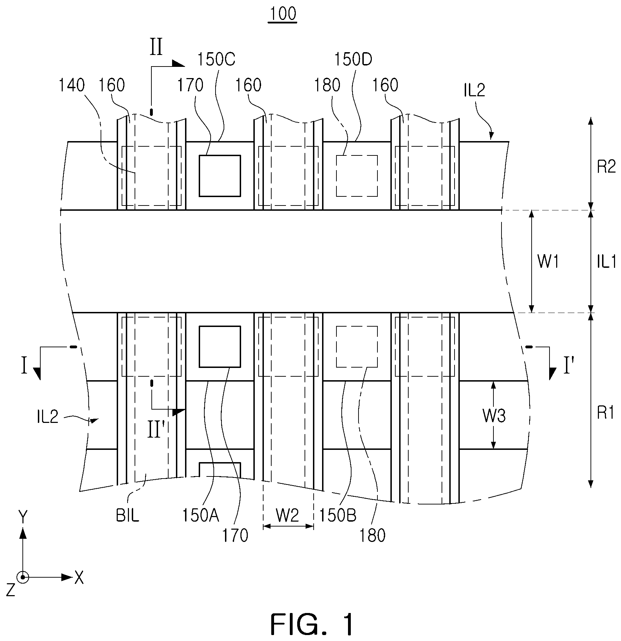

FIG. 1 is a plan view of a semiconductor device according to example embodiments of the present inventive concept.

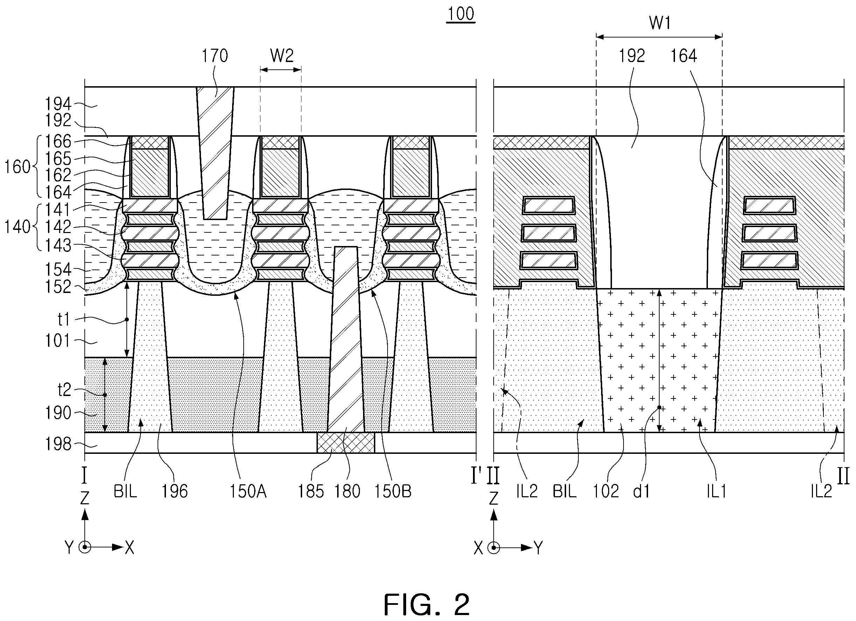

FIG. 2 is a cross-sectional view of a semiconductor device according to example embodiments of the present inventive concept. FIG. 2 is a cross-sectional view of the semiconductor device of FIG. 1, taken along lines I-I' and II-II'.

Referring to FIGS. 1 and 2, a semiconductor device 100 may include a semiconductor substrate 101 including first and second regions R1 and R2, a substrate insulating layer 190 disposed on a lower surface of the semiconductor substrate 101, gate structures 160 disposed on the semiconductor substrate 101 and extending along Y - direction, the gate structures 160 respectively including a gate electrode 165, channel structures 140 including first to third channel layers 141, 142 and 143 disposed on the semiconductor substrate 101, first to fourth source/drain regions 150A, 150B, 150C, and 150D in contact with the channel structures 140, front contact plugs 170 passing through first and second interlayer insulating layers 192 and 194, and backside contact plugs 180 passing through the substrate insulating layer 190 and the semiconductor substrate 101. The first to third channel layers 141, 142 and 143 may be spaced apart from each other along a vertical direction. The front contact plugs 170 may be connected to the first and third source/drain regions 150A and 150C. The backside contact plugs 180 may be connected to the second and fourth source/drain regions 150B and 150D. The semiconductor device 100 may further include first to third interlayer insulating layers 192, 194, and 198, and may further include first and second isolation regions IL1 and IL2 defining an active region 105, which is on the semiconductor substrate 101, and a backside isolation region BIL isolating the semiconductor substrate 101. For example, the backside isolation region BIL may be disposed between the semiconductor substrates 101 (e.g. between separate portions of the semiconductor substrate 101) and may separate the semiconductor substrate 101 from an adjacent semiconductor substrate 101 (e.g. may separate adj acent portions of the semiconductor substrate 101). The semiconductor device 100 may further include backside power structures 185 connected to the backside contact plugs 180. For example, the backside power structures 185 may be disposed below the backside contact plugs 180.

The semiconductor substrate 101 may include first and second regions R1 and R2. The first and second regions R1 and R2 may be disposed adjacent to each other or may be spaced apart from each other. First and second source/drain regions 150A and 150B may be disposed in the first region R1, and third and fourth source/drain regions 150C and 150D may be disposed in the second region R2. For example, the first region R1 may be an n-channel field-effect transistor (nFET) region, and the second region R2 may be a p-channel field-effect transistor (pFET) region. However, in some example embodiments of the present inventive concept, the first and second regions R1 and R2 may be regions in which transistors having the same conductivity type and different electrical properties are disposed. That is, the first and second regions R1 and R2 may comprise transistors having one or both of different conductivity types and different electrical properties. Alternatively, the first and second regions R1 and R2 may comprise transistors having the same conductivity type and the same electrical properties. The first and second regions R1 and R2 may be referred to as regions of the semiconductor device 100 rather than regions of the semiconductor substrate 101.

The semiconductor substrate 101 may include an upper surface extending in an X-direction and a Y-direction, and a lower surface disposed opposite to the upper surface (e.g. in a Z-direction). The X-direction may be a first direction running parallel to the upper surface of the semiconductor substrate 101. The Y-direction may be a second direction running parallel to the upper surface of the semiconductor substrate 101. The Z-direction may be a third direction running perpendicular to the upper surface of the semiconductor substrate 101. The X-direction may cross (e.g. may be perpendicular to) the Y-direction. The Z-direction may cross (e.g. may be perpendicular to) the X-direction and the Y-direction. The semiconductor substrate 101 may include silicon (Si), germanium (Ge), or silicon germanium (SiGe). The semiconductor substrate 101 may include a bulk wafer, an epitaxial layer, a silicon-on-insulator (SOI) layer, or a semiconductor-on-insulator (SeOI) layer.

A first thickness t1 of the semiconductor substrate 101 may be a length measured along a Z-direction from the lower surface to the upper surface of the semiconductor substrate 101. A length d1 may be a length of the first isolation region IL1 measured along the Z-direction. The first thickness t1 may be less than the length d1.

The substrate insulating layer 190 may be a layer disposed on the lower surface of the semiconductor substrate 101. The substrate insulating layer 190 may be formed after partially removing the semiconductor substrate 101 during a manufacturing process. The substrate insulating layer 190 may be formed of an insulating material, and may include, for example, oxide, nitride, or a combination thereof. In some example embodiments of the present inventive concept, the substrate insulating layer 190 may include a plurality of insulating layers, and may be disposed on the lower surface of the semiconductor substrate 101. A second thickness t2 may be a length of the substrate insulating layer 190 measured along a the Z-direction. The second thickness t2 of the substrate insulating layer 190 may be equal to or greater than the first thickness t1. The second thickness t2 of the substrate insulating layer 190 may satisfy a range of 1 to 2 times the first thickness t1 of the semiconductor substrate 101. The second thickness t2 of the substrate insulating layer 190 may range from about 1 to about 1.2 times the first thickness t1, but the present inventive concept is not necessarily limited thereto.

The substrate insulating layer 190 and the semiconductor substrate 101 may be collectively referred to as a substrate structure. The substrate structure may include a first region R1 and a second region R2 in the same manner as the semiconductor substrate 101.

In the substrate structure, the first region R1 and the second region R2 may be spaced apart from each other along the Y-direction. The first isolation region IL1 may be disposed between the first region R1 and the second region R2 and may extend along the X-direction. An upper surface of the first isolation region IL1 may be disposed at the same level as, or similar to, the upper surface of the semiconductor substrate 101. A lower surface of the first isolation region IL1 may be disposed at the same level as, or similar to, a lower surface of the substrate insulating layer 190. For example, the lower surface of the first isolation region IL1 may be coplanar with the lower surface of the substrate insulating layer 190. A width (e.g. in the Y-direction) of the lower surface of the first isolation region IL1 may be less than a first width W1 (e.g. in the Y-direction), which is a width the upper surface of the first isolation region IL1. For example, the width of the first isolation region IL1 may gradually decrease along the Z-direction from the upper surface to the lower surface. Accordingly, the first isolation region IL1 may have inclined side surfaces. In an X-Y plane, the first width W1 may be greater than a second width W2, which is the length of the gate structure 160 measured along the X-direction. The second width may be a width of the gate electrode 165.

In the first region R1 and the second region R2 of the substrate structure, the second isolation region IL2 may isolate the respective active regions 105 from each other. Accordingly, the active regions 105 may be separated from each other in the Y-direction. The second isolation region IL2 may include an upper surface having a third width W3, which is measured along the Y-direction. The third width W3 of the second isolation region IL2 may be less than the first width W1 of the first isolation region IL1. The upper surface of the second isolation region IL2 may be coplanar with the upper surface of the first isolation region IL1, and a lower surface of the second isolation region IL2 may be coplanar with the lower surface of the first isolation region IL1. The first isolation region IL1 and the second isolation region IL2 may have the same length d1 measured along the Z-direction, and the length d1 may be substantially equal to a sum of the first thickness t1 of the semiconductor substrate 101 and the second thickness t2 of the substrate insulating layer 190. The first isolation region IL1 and the second isolation region IL2 may include the same material 102. For example, the first isolation region IL1 and the second isolation region IL2 may include an insulating material 102, may include at least one of an oxide, nitride, oxynitride, and oxycarbide, and may include one of silicon oxide and silicon nitride.

In each of the first region R1 and the second region R2, the gate structures 160 may be disposed on the upper surface of the semiconductor substrate 101 and may extend along a single direction. For example, in the first region R1 and the second region R2 the gate structures 160 may extend along the Y-direction. The gate structures 160 of the first region R1 and the second region R2 may be disposed in a cut state so as not to be disposed on an upper portion of the first isolation region IL1, which is between the first region R1 and the second region R2. The gate structures 160 may extend along the Y-direction and may cover an upper portion of the second isolation region IL2 in each of the first region R1 and the second region R2.

Channel regions of transistors may be disposed in the channel structure 140, intersecting the gate electrodes 165 of the gate structures 160. The gate structures 160 may be spaced apart from each other along the X-direction. Each of the gate structures 160 may include gate dielectric layers 162, gate spacer layers 164, and a gate electrode 165. In example embodiments, each of the gate structures 160 may further include a capping layer 166 disposed on an upper surface of the gate electrode 165.

The gate dielectric layers 162 may be disposed between the active region 105 and the gate electrode 165 and between the channel structure 140 and the gate electrode 165. The gate dielectric layers 162 may partially cover part of the surfaces of the gate electrode 165. For example, the gate dielectric layers 162 may surround surfaces of the gate electrode 165, excluding an uppermost surface (which may be covered by the capping layer 166). The gate dielectric layers 162 may be disposed in a space between the gate electrode 165 and the gate spacer layers 164, but the present inventive concept is not necessarily limited thereto. The gate dielectric layer 162 may include, for example, oxide, nitride, or a high-κ material. A high-κ material may refer to a dielectric material having a dielectric constant, higher than that of a silicon oxide film (SiO₂). The high-κ material may include, for example, one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). In some example embodiments of the present inventive concept, the gate dielectric layer 162 may be a multilayer structure.

The gate electrode 165 may include a conductive material, for example, a metal nitride such as a titanium nitride film (TiN), a tantalum nitride film (TaN), or a tungsten nitride film (WN), and/or a metal material such as aluminum (Al), tungsten (W), or molybdenum (Mo), or a semiconductor material such as doped polysilicon. In some example embodiments of the present inventive concept, the gate electrode 165 may be a multilayer structure. The gate electrodes 165 may be connected to upper contact plugs disposed thereon.

The gate spacer layers 164 may be disposed on both side surfaces of the gate electrode 165 and may be disposed on the channel structure 140. The gate spacer layers 164 may insulate the first to fourth source/drain regions 150A to 150D and the gate electrodes 165 from each other. The gate spacer layers 164 may also be disposed on side surfaces, of the gate structures 160 cut on the first isolation region IL1. Accordingly, the upper surface of the first isolation region IL1 may be in direct contact with lower surfaces of the gate spacer layers 164, but the present inventive concept is not necessarily limited thereto. In some example embodiments of the present inventive concept, a shape of an upper end of each of the gate spacer layers 164 may be changed in various manners, and the gate spacer layers 164 may be multilayer structures. The gate spacer layers 164 may include at least one of an oxide, nitride, and oxynitride, and may be formed of, for example, a low-κ film. A low-κ material may refer to a dielectric material having a dielectric constant, lower than that of a silicon oxide film (SiO₂).

The channel structures 140 may be disposed on the semiconductor substrate 101 and may intersect the gate structures 160. Each of the channel structures 140 may include first to third channel layers 141, 142 and 143, which are spaced apart from each other along the Z-direction. The channel structures 140 may be connected to the first to fourth source/drain regions 150A to 150D. The channel structures 140 may have a width measured along the X-direction, which is equal to or similar to that of the gate structures 160. In a cross-section view along the Y-direction, a lower channel layer, among the first to third channel layers 141, 142 and 143, may have a width equal to or greater than that of an upper channel layer, among the first to third channel layers 141, 142 and 143. For example, the third channel layer 143 may have a width equal to or greater than that of the first channel layer 141. In some example embodiments of the present inventive concept, a width of the channel structures 140 may be smaller than a width of the gate structures 160.

The channel structures 140 may be formed of a semiconductor material, and may include at least one of, for example, silicon (Si), silicon germanium (SiGe), and germanium (Ge). In some example embodiments of the present inventive concept, the number and shape of the channel layers 141, 142 and 143 included in a single channel structure 140 may vary.

In the semiconductor device 100, the gate electrode 165 may be disposed between the first to third channel layers 141, 142, and 143 and may be disposed on the channel structures 140. Accordingly, the semiconductor device 100 may include a transistor having a multi-bridge channel field-effect transistor (FET) structure, such as MBCFET^{™} marketed by SAMSUNG, featuring a gate-all-around type field effect transistor.

The first to fourth source/drain regions 150A, 150B, 150C, and 150D may be disposed at both sides of the gate structures 160 (e.g. both sides in the X-direction) and may be in contact with the channel structures 140, respectively. For example, the first to fourth source/drain regions 150A, 150B, 150C, and 150D may be disposed between the gate structures 160. The first to fourth source/drain regions 150A, 150B, 150C, and 150D may cover side surfaces of each of the first to third channel layers 141, 142 and 143 of the channel structure 140. The first and third source/drain regions 150A and 150C may be connected to the front contact plugs 170 through upper surfaces or upper ends thereof, respectively, and the second and fourth source/drain regions 150B and 150D may be connected to the backside contact plugs 180 through lower surfaces or lower ends, respectively. For example, the front contact plugs 170 may penetrate the first and third source/drain regions 150A and 150C and the backside contact plugs 180 may penetrate the second and fourth source/drain regions 150B and 150D. The first to fourth source/drain regions 150A, 150B, 150C, and 150D may have recessed shapes due to the front contact plugs 170 and the backside contact plugs 180. The upper surfaces of the first to fourth source/drain regions 150A, 150B, 150C, and 150D may be disposed on the same or higher level than that of a lower surface of the gate electrode 165 disposed on the channel structure 140. For instance, the upper surfaces of the first to fourth source/drain regions 150A, 150B, 150C, and 150D may be disposed on the same or higher level than that of an upper surface of the channel structure 140. However, it is not necessarily limited thereto and the level may be changed in various manners in example embodiments of the present inventive concept.

Each of the first to fourth source/drain regions 150A, 150B, 150C, and 150D may include first and second epitaxial layers 152 and 154. The first epitaxial layer 152 may cover side surfaces of each of the first to third channel layers 141, 142 and 143, and may cover side surfaces of the channel structure 140, which is disposed below the gate structures 160. The first epitaxial layers 152 may cover an inner sidewall and a lower surface of a recess region in which each of the first to fourth source/drain regions 150A, 150B, 150C, and 150D is disposed. The first epitaxial layer 152 may have an external convex shaped surface that protrudes toward the gate structure 160, disposed below each of the first to third channel layers 141, 142 and 143. Accordingly, the first epitaxial layer 152 may have an external surface with a curved shape, which bulges outward in a rounded manner. However, a shape of the external surface of the first epitaxial layer 152 is not necessarily limited to the shape illustrated in FIG. 2. In the second and fourth source/drain regions 150B and 150D, the backside contact plugs 180 may pass through the first epitaxial layer 152, and the first epitaxial layer 152 may be in contact with the backside contact plugs 180.

The second epitaxial layer 154 may cover the first epitaxial layer 152, and may fill the recess region (e.g. may fill the remainder of the recess region not occupied by the first epitaxial layer 152). In the second and fourth source/drain regions 150B and 150D, the second epitaxial layer 154 may be in contact with part of an upper portion of the backside contact plugs 180. A width of the second epitaxial layer 154, which is measured along the X-direction, may be greater than a thickness of the first epitaxial layer 152 disposed on one side surface of the channel structure 140. In some example embodiments of the present inventive concept, each of the first to fourth source/drain regions 150A, 150B, 150C, and 150D may further include a third epitaxial layer disposed on an upper surface of the second epitaxial layer 154.

The first to fourth source/drain regions 150A, 150B, 150C, and 150D may include a semiconductor material, for example, at least one of silicon (Si) and germanium (Ge), and may further include impurities. The first and second epitaxial layers 152 and 154 may have different compositions. For example, a concentration of a non-silicon element of the second epitaxial layer 154 may be higher than a concentration of a non-silicon element of the first epitaxial layer 152. The non-silicon element may be, for example, germanium (Ge) and/or a doping element.

For example, when the first region R1 is an nFET region and the second region R2 is a pFET region, the third and fourth source/drain regions 150C and 150D might not include germanium (Ge), or may include germanium (Ge) having a concentration, lower than those of the first and second source/drain regions 150A and 150B. For example, the first and second source/drain regions 150A and 150B may include silicon (Si). For example, the third and fourth source/drain regions 150C and 150D may include silicon germanium (SiGe), and a concentration of germanium (Ge) of the second epitaxial layer 154 may be greater than a concentration of germanium (Ge) of the first epitaxial layer 152.

A doping concentration of a doping element, that is, impurities, of the second epitaxial layer 154 may be higher than that of the first epitaxial layer 152. Accordingly, a specific resistance (e.g. resistivity) of the second epitaxial layer 154 may be less than that of the first epitaxial layer 152. In each of the source/drain regions 150A, 150B, 150C and 150D, a doping type of the first epitaxial layer 152 may be the same as a doping type of the second epitaxial layer 154. For example, the impurities of the first and second source/drain regions 150A and 150B may include N-type impurities, such as at least one of phosphorus (P), arsenic (As), and antimony (Sb) and the impurities of the third and fourth source/drain regions 150C and 150D may include P-type impurities, such as at least one of boron (B), gallium (Ga), and indium (In). For example, an impurity concentration of the first epitaxial layer 152 may range from about 1×10²⁰/cm³ to about 6×10²¹/cm³, and an impurity concentration of the second epitaxial layer 154 may range from about 1×10²¹ /cm³ to about 1×10²² /cm³, but the present inventive concept is not necessarily limited thereto.

The front contact plugs 170 may pass through the first and second interlayer insulating layers 192 and 194, may be connected to the first and third source/drain regions 150A and 150C, and may apply an electrical signal to the first and third source/drain regions 150A and 150C. The front contact plugs 170 may have side surfaces that taper, with a lower width narrower than the upper width according to an aspect ratio, but the present inventive concept is not necessarily limited thereto. The upper surfaces of the first and third source/drain regions 150A and 150C may be recessed and may create space for the front contact plugs 170 to be disposed. For example, the front contact plugs 170 may extend from the upper surfaces of the first and third source/drain regions 150A and 150C (e.g. into the first and third source/drain regions 150A and 150C), creating a concave downward curvature in the top surfaces of the first and third source/drain regions 150A and 150C.

The front contact plugs 170 may recess the first and third source/drain regions 150A and 150C to substantially the same depth. The front contact plugs 170 may extend from an upper portion to a portion below a lower surface of an uppermost first channel layer 141 of the channel structure 140, but the present inventive concept is not necessarily limited thereto. For example, lower ends of the front contact plugs 170 may be disposed, for example, on a level between an upper surface of the first channel layer 141 and an upper surface of the second channel layer 142. For example, the lower ends of the front contact plugs 170 may be disposed on a level between upper and lower surfaces of the second channel layer 142.

The front contact plug 170 may include a metal material, for example, tungsten (W), molybdenum (Mo), or aluminum (Al). In some example embodiments of the present inventive concept, the front contact plug 170 may include a barrier layer forming an external surface. The barrier layer may include, for example, a metal nitride such as titanium nitride (TiN), tantalum nitride (TaN), or tungsten nitride (WN). In example embodiments of the present inventive concept, the number and arrangement of conductive layers, included in the front contact plug 170, may be changed in various manners.

The backside contact plugs 180 may be disposed below the second and fourth source/drain regions 150B and 150D. The backside contact plugs 180 may pass through the semiconductor substrate 101 from the lower surface of the substrate insulating layer 190, and may be connected to the second and fourth source/drain regions 150B and 150D, respectively. The backside contact plugs 180 may pass through the semiconductor substrate 101 and the substrate insulating layer 190 from the lower surface of the substrate insulating layer 190.

Each of the backside contact plugs 180 may include a lower region that passes through the substrate insulating layer 190. The lower region may have a lower surface that is coplanar with the lower surface of the substrate insulating layer 190. The lower region of the backside contact plugs 180 may have a width that decreases upward as it passes through the substrate insulating layer 190. The backside contact plugs 180 may include an intermediate region disposed on the lower region. The intermediate region may pass through the semiconductor substrate 101. The backside contact plugs may include an upper region disposed on the intermediate region, the upper region recessing the second and fourth source/drain regions 150B and 150D. The lower region, the intermediate region, and the upper region may have a shape with a width that decrease upward along the Z-direction. Each of the backside contact plugs 180 has an inclined side surface connecting the upper surface and the lower surface. The side surface of the backside contact plugs 180 may have a continuous inclination with respect to the lower region and the upper region, but the present inventive concept is not necessarily limited thereto.

The backside contact plugs 180 may be in contact with both the first and second epitaxial layers 152 and 154. The backside contact plugs 180 may be in contact with the first epitaxial layers 152 in lower regions of the second and fourth source/drain regions 150B and 150D, and may be in contact with the second epitaxial layers 154 at upper ends thereof. The upper ends of the backside contact plugs 180 may be disposed at a higher level than the lower regions of the second and fourth source/drain regions 150B and 150D. For example, the backside contact plugs 180 may further extend along the Z-direction after penetrating the second and fourth source/drain regions 150B and 150D. The upper ends of the each of the backside contact plugs 180 may be at different levels from each other.

The backside contact plugs 180 may overlap at least one of the first to third channel layers 141, 142 and 143 along the X-direction. For example, the backside contact plugs 180 may partially overlap the third channel layer 143 along the X-direction. For example, the backside contact plugs 180 may partially overlap the second and third channel layers 142 and 143 along the X-direction.

The backside contact plug 180 may include a material, the same as that of the front contact plugs 170, and may include a metal material such as aluminum (Al), tungsten (W), or molybdenum (Mo). The backside contact plug 180 may further include a barrier layer surrounding a surface thereof, and the barrier layer may include, for example, a metal nitride such as a titanium nitride film (TiN), a tantalum nitride film (TaN), or a tungsten nitride film (WN).

Backside isolation regions BIL may be disposed below the gate structures 160, respectively. The backside isolation regions BIL may have a linear shape and may overlap the gate structure 160 on an X-Y plane, and may extend along the Y-direction. The backside isolation regions BIL may overlap a portion of the gate structure 160, and may be disposed in the form of a wall to physically and electrically separate the semiconductor substrate 101 disposed below one of the source/drain region 150A to 150D from an adjacent semiconductor substrate 101. For instance, the semiconductor substrate 101 may be separated into different portions by the backside isolation regions BIL.

Accordingly, the backside isolation regions BIL may overlap a portion of the gate structures 160, disposed at both sides of the source/drain regions 150A to 150D, but the present inventive concept is not necessarily limited thereto. For example, the backside isolation regions BIL may be implemented in various manners as long as the backside isolation regions BIL provide a structure separating the semiconductor substrate 101 disposed below the source/drain regions 150A to 150D and the semiconductor substrate 101 disposed below adjacent source/drain regions 150A to 150D from each other. However, when the backside contact plugs 180 are disposed on a lower surface of the semiconductor substrate 101, the backside isolation regions BIL may be preferably disposed below the gate structure 160 to secure a sufficient separation distance from the backside contact plugs 180.

The backside isolation regions BIL may include a lower region passing through the substrate insulating layer 190 and an upper region disposed on the lower region. The lower region may have a lower surface coplanar with the lower surface of the substrate insulating layer 190. The lower region may have a shape with a width that decreases upward along the Z-direction. The upper region of the backside isolation regions BIL may pass through the semiconductor substrate 101. An upper surface of each of the backside isolation regions BIL, which includes an upper end of the upper region, may be in contact with a lower surface of a lowermost gate dielectric layer 162 of the gate structure 160. The upper region of the backside isolation regions BIL may have a width smaller than that of the lower region, and may have a shape with a width that tapers upward. Each of the backside isolation regions BIL may have an inclined side surface connecting the upper surface and the lower surface. The side surface of the backside isolation regions BIL may have a continuous inclination with respect to the lower region and the upper region, but is not necessarily limited thereto.

When the backside isolation regions BIL divide the substrate structure into a plurality of active regions 105 having a linear shape disposed below each gate structure 160, the backside isolation regions BIL may intersect the first isolation region IL1 in an X-Y-direction (e.g. in the X-direction) and form a lattice shape. The backside isolation regions BIL may intersect second isolation regions IL2 in an X-Y-direction (e.g. in the X-direction) and form a lattice shape.

The backside isolation regions BIL may also include an insulating material 196, at least one of an oxide, nitride, oxynitride, and oxycarbide, and for example, silicon oxide or silicon nitride, but the present inventive concept is not necessarily limited thereto.

The backside isolation regions BIL may be disposed in an intersection region in which the backside isolation regions BIL intersect the first isolation region IL1, and may have a shape in which the first isolation region IL1 is cut. However, when the backside isolation regions BIL and the first isolation region IL1 include the same material, the substrate structure may include an isolated region with a lattice shape that defines the first to fourth source/drain regions 150A to 150D in the first and second regions R1 and R2, without a boundary. However, the present inventive concept is not necessarily limited thereto.

When the backside isolation regions BIL overlap the gate structure 160 along the Z-direction, the backside isolation regions BIL may have a width, measured along the X-direction, less than the second width W2, but the present inventive concept is not necessarily limited thereto.

As illustrated in FIG. 2, the lower surface of the substrate insulating layer 190 may be coplanar with lower surfaces of the backside isolation regions BIL, lower surfaces of the backside contact plugs 180, and lower surfaces of the first and second isolation regions IL1 and IL2.

The backside power structure 185 may be connected to lower ends or lower surfaces of the backside contact plugs 180. The backside power structure 185, together with the backside contact plug 180, may form a buried source/drain power network (BSPDN) for applying power or ground voltage, and may be referred to as a lower surface power rail or a buried power rail. For example, the backside power structure 185 may be a buried interconnection line extending along one direction, for example, in the Y-direction, below the backside contact plug 180, but a shape of the backside power structure 185 is not necessarily limited thereto. For example, in some example embodiments of the present inventive concept, the backside power structure 185 may include a via region and/or a line region. A width of the backside power structure 185 may continuously downwardly increase, but the present inventive concept is not limited thereto.

The backside power structure 185 may include a conductive material, for example, at least one of tungsten (W), copper (Cu), aluminum (Al), cobalt (Co), ruthenium (Ru), titanium (Ti), and molybdenum (Mo).

The first interlayer insulating layer 192 may cover the upper surfaces of the first to fourth source/drain regions 150A to 150D and the upper surface of the first isolation region IL1. The second interlayer insulating layer 194 may cover an upper surface of the first interlayer insulating layer 192 and upper surfaces of the gate structures 160. The third interlayer insulating layer 198 cover the lower surface of the substrate insulating layer 190 and may surround side surfaces of the backside power structure 185.

The first to third interlayer insulating layers 192, 194, and 198 may include at least one of an oxide, nitride, and oxynitride, and may include, for example, a low-κ material. **In** some example embodiments of the present inventive concept, each of the first to third interlayer insulating layers 192, 194, and 198 may include a plurality of insulating layers.

The semiconductor device 100 may be packaged by vertically inverting the structure of FIG. 2 such that the backside power structure 185 is positioned thereon, but a packaging type of the semiconductor device 100 is not necessarily limited thereto. The source/drain regions 150 may be connected to the backside power structure 185 therebelow through the backside contact plug 180, thereby increasing a degree of integration.

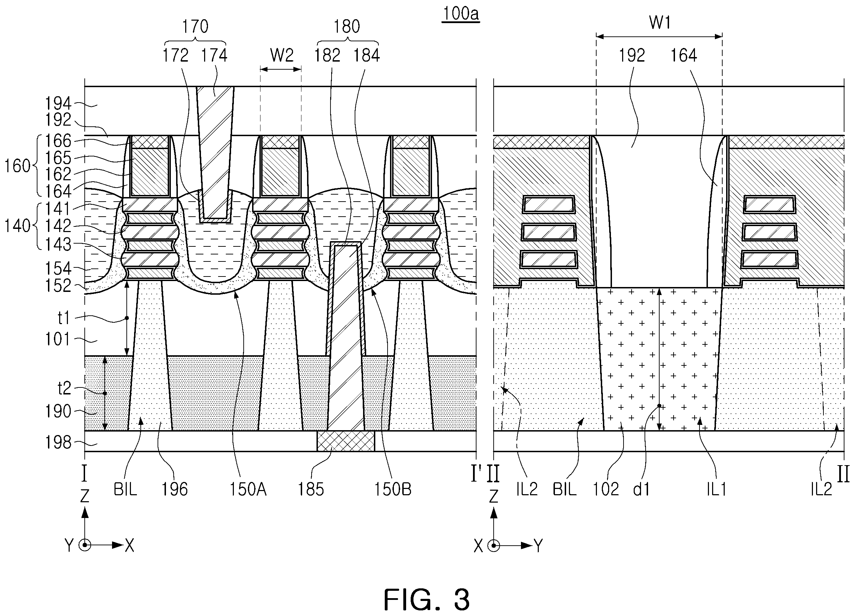

Hereinafter, semiconductor devices according to example embodiments of the present inventive concept will be described with reference to FIGS. 3 to 6. To the extent that an element has not been described in detail, it may be assumed that the element is at least similar to corresponding elements that have been described in FIGS. 1 and 2.

Referring to FIG. 3, in a semiconductor device 100a, backside contact plugs 180 may include a metal-semiconductor compound layer 182 and a conductive layer 184. The metal-semiconductor compound layer 182 may cover external surfaces of an intermediate region and an upper region of the backside contact plugs 180. The metal-semiconductor compound layer 182 may be disposed at a contact interface between the backside contact plugs 180 and the semiconductor substrate 101 and second and fourth source/drain regions 150B and 150D.

The metal-semiconductor compound layer 182 may be positioned on a portion of an upper surface and a side surface of the backside contact plug 180. The metal-semiconductor compound layer 182 may be disposed in a region in which at least the backside contact plug 180 is in contact with a second epitaxial layer 154. However, in example embodiments of the present inventive concept, a scope of the metal-semiconductor compound layer 182 is not necessarily limited. The metal-semiconductor compound layer 182 may be, for example, a metal silicide layer. The conductive layer 184 may fill a contact hole surrounded by the metal-semiconductor compound layer 182. The conductive layer 184 may include a metal material, for example, aluminum (Al), tungsten (W), or molybdenum (Mo). In example embodiments of the present inventive concept, the number and arrangement of conductive layers, included in the backside contact plug 180, may be changed in various manners.

The conductive layer 184 may be in direct contact with a substrate insulating layer 190 in a lower region of the backside contact plug 180, and may be connected to the semiconductor substrate 101 and the second and fourth source/drain regions 150B and 150D through the metal-semiconductor compound layer 182 in the intermediate and upper regions of the backside contact plug 180.

The front contact plugs 170 may also include a conductive layer 174 and a metal-semiconductor compound layer 172. The metal-semiconductor compound layer 172 may be disposed in a lower region of the front contact plugs 170 that is in contact with source/drain regions 150A and 150C, and the conductive layer 174 may vertically extend from an upper surface of the front contact plugs 170 to the lower region of the front contact plugs 170. The conductive layer 174 may be in direct contact with first and second interlayer insulating layers 192 and 194 disposed on upper portions of the source/drain regions 150A and 150C. The metal-semiconductor compound layer 172 may be, for example, a metal silicide layer. The conductive layer 174 may fill a contact hole surrounded by the metal-semiconductor compound layer 172. The conductive layer 174 may include, for example, a metal material such as aluminum (Al), tungsten (W), or molybdenum (Mo).

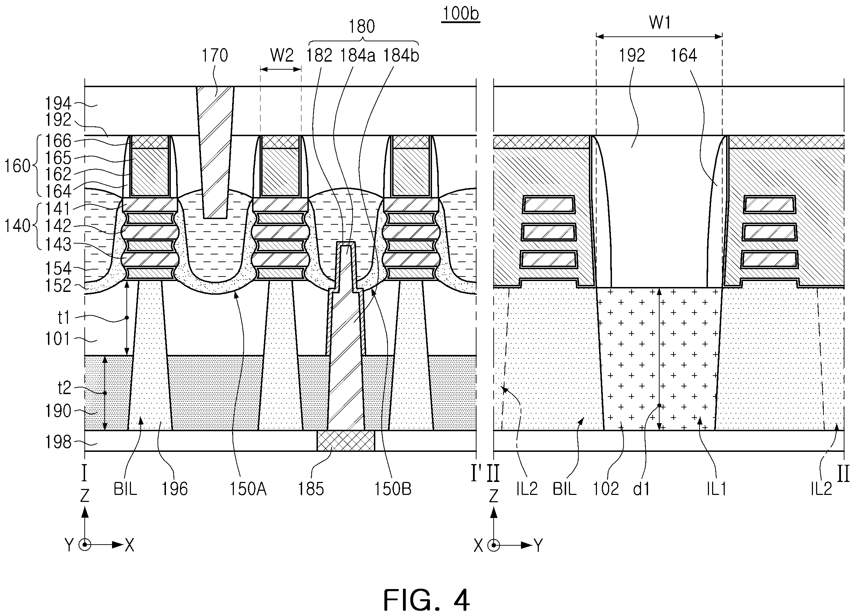

Referring to FIG. 4, a semiconductor device 100b may be the same as the semiconductor devices of FIGS. 2 and 3, except for a shape of each of backside contact plugs 180. To the extent that an element has not been described in detail, it may be assumed that the element is at least similar to corresponding elements that have been described in FIGS. 2 and 3.

The backside contact plugs 180 may include a bent portion between an intermediate region 184b and an upper region 184a.

The bent portion of the backside contact plugs 180 may have a shape that the width of a lower end of an upper region 184a, which is in contact with source/drain regions 150B and 150D, decreases more rapidly than a width of an upper end of the intermediate region 184b. For example, a lower portion of the upper region 184a is narrower than an upper portion of the intermediate region 184b, with the bent portion forming at the point where the width changes rapidly between the two portions. Accordingly, the backside contact plugs 180 may include a bent portion having a width decreasing from a lower surface thereof to an upper surface thereof, the width discontinuously decreasing between the intermediate region 184b and the upper region 184a. As illustrated in FIG. 3, when the metal-semiconductor compound layer 182 is included, the metal-semiconductor compound layer 182 may surround the bent portion.

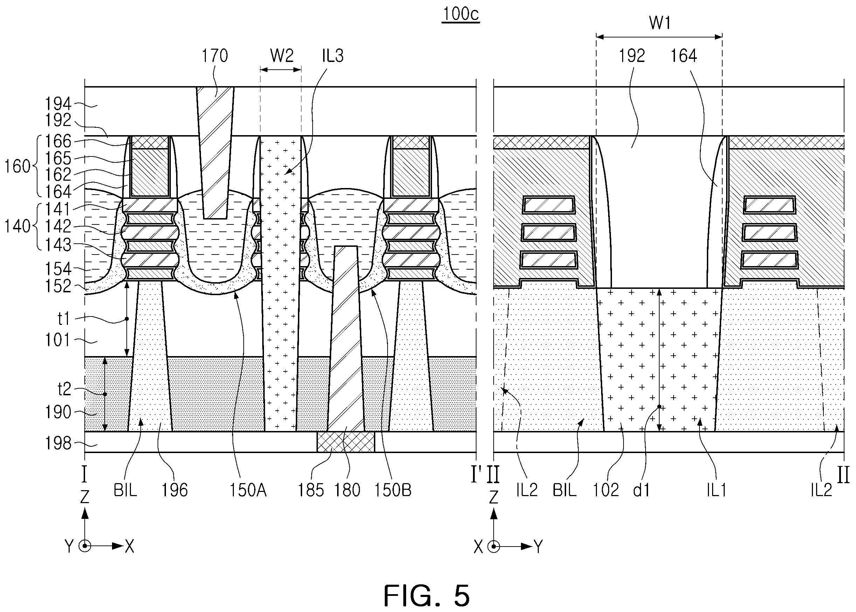

Referring to FIG. 5, a semiconductor device 100c may further include a gate isolation region IL3.

The gate isolation region IL3 may be disposed in a region in which a gate structure 160 is disposed, on an X-Y plane. For example, the gate isolation region IL3 may have a linear shape extending along a Y-direction to be parallel to adjacent gate structures 160. The gate isolation region IL3 may be disposed between the adjacent gate structures 160.

The gate isolation region IL3 may extend from the gate structure 160 towards a substrate insulating layer 190 in a region in which the gate structure 160 is disposed. The gate isolation region IL3 may pass through a first interlayer insulating layer 192 and the substrate insulating layer 190. Accordingly, the gate isolation region IL3 may be a wall-shaped structure passing through the semiconductor device 100c along the Z-direction and extending in a linear shape in the Y-direction. At least one gate isolation region IL3 may be disposed in a first region R1 or a second region R2. In the gate isolation region IL3, when the source and drain of adjacent transistors are electrically isolated from each other, the transistors may be configured such that the intermediate gate structure 160 connects to the channel structure 140 and the underlying semiconductor substrate 101, forming source/drain regions 150A to 150D, respectively. The adjacent transistors, each having gate structures 160 on both sides, may be electrically isolated from one another by the gate isolation region IL3.

The gate isolation region IL3 may be disposed to be parallel to a backside isolation region BIL disposed below gate structures 160 at both sides thereof. However, a length of the gate isolation region IL3 measured along the Z-direction may be greater than that of the backside isolation region BIL.

An upper surface of the gate isolation region IL3 may be coplanar with upper surfaces of the first interlayer insulating layer 192 and the gate structures 160, and a lower surface of the gate isolation region IL3 may be coplanar with a lower surface of the substrate insulating layer 190. Accordingly, a lower surface of the gate isolation region IL3 may be coplanar with a lower surface of the backside isolation region BIL and a lower surface of the backside contact plug 180. A width of the gate isolation region IL3 may taper gradually from an upper surface to a lower surface, with inclined side surfaces connecting the upper surface and the lower surface.

In an upper region of the gate isolation region IL3, the side surfaces may be in contact with gate spacer layers 164, but the present inventive concept is not necessarily limited thereto. The gate isolation region IL3 may include an insulating material, and may include at least one of an oxide, nitride, oxynitride, or oxycarbide. For example, silicon oxide or silicon nitride may be included, but the present inventive concept is not necessarily limited thereto.

The gate isolation region IL3 may include the same material as the first and second isolation regions IL1 and IL2. The gate isolation region IL3 may have a lower surface disposed on a same level as the lower surfaces of the first and second isolation regions IL1 and IL2, and may have an upper surface disposed on a same or higher level than the upper surfaces of the first and second isolation regions IL1 and IL2. For example, the gate isolation region IL3 may have a length, measured along the Z-direction, greater than those of the first and second isolation regions IL1 and IL2.

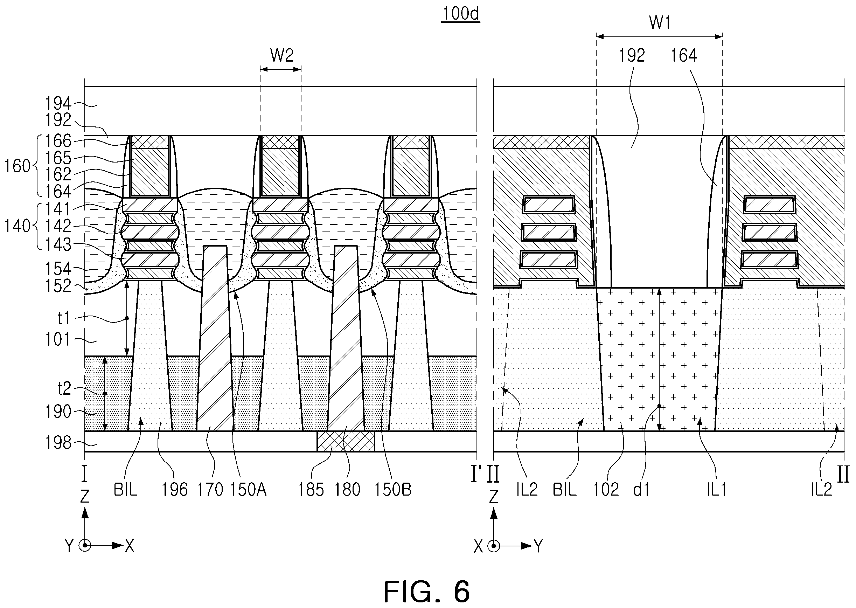

Referring to FIG. 6, in a semiconductor device 100d, front contact plugs 170 might not be disposed, and backside contact plugs 180 may be disposed in adjacent source/drain regions 150A to 150D, respectively.

The backside contact plugs 180 may be disposed in the first, second, third, and fourth source/drain regions 150A, 150B, 150C, and 150D, which are disposed at both sides of the gate structure 160, such that contact plugs 180 for applying signals to the first, second, third, and fourth source/drain regions 150A, 150B, 150C, and 150D may be disposed along the same direction as the first to fourth source/drain regions 150A to 150D. As described, the contact plugs 180 may pass through a lower surface of a semiconductor device 100d. For example, the contact plugs 180 may avoid electrical contact with the gate structure 160, thereby preventing a short-circuit with the gate structure 160.

A plurality of backside contact plugs 180, respectively formed in the first, second, third, and fourth source/drain regions 150A, 150B, 150C, and 150D, may have the same shape, and the shape may be applied to one of the backside contact plugs 180 of FIGS. 2 to 4. One of two contact plugs 180, among the backside contact plugs 180, may be connected to a backside power structure 185.

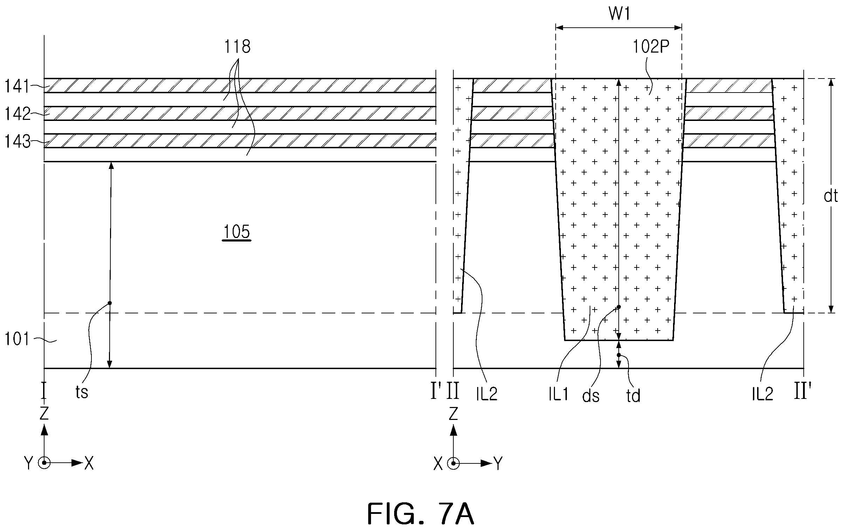

FIGS. 7A to 7I are diagrams illustrating sequential processes in a method of manufacturing a semiconductor device according to example embodiments of the present inventive concept. In FIGS. 7A to 7I, an example embodiment of the present inventive concept of a method of manufacturing a power semiconductor device of FIGS. 1 and 2 will be described. FIGS. 7A to 7I are respectively illustrating cross-sections taken along lines I-I' and II-II' of FIG. 1.

Referring to FIG. 7A, sacrificial layers 118 and first to third channel layers 141, 142, and 143 may be alternately stacked on a substrate 101. For example, sacrificial layers 118 may be stacked between the first to third channel layers 141, 142, and 143.

The semiconductor substrate 101 may include silicon (Si), germanium (Ge), or silicon germanium (SiGe). The semiconductor substrate 101 may include a bulk wafer, an epitaxial layer, a silicon-on-insulator (SOI) layer, or a semiconductor-on-insulator (SeOI) layer.

The semiconductor substrate 101 may have an initial thickness ts, which is greater than the first thickness t1 illustrated in FIG. 2. The initial thickness ts of the semiconductor substrate 101 may be greater than a sum of the first thickness t1 and the second thickness t2 of the substrate insulating layer 190 illustrated in FIG. 2.

The sacrificial layers 118 may be replaced with gate dielectric layers 162 and gate electrodes 165 through a subsequent process, as illustrated in FIG. 2. The sacrificial layers 118 may include a material having an etch selectivity with respect to each of first to third channel layers 141, 142, and 143. For example, the sacrificial layers 118 may be selectively etched without significantly affecting the first to third channel layers 141, 142, and 143. The first to third channel layers 141, 142 and 143 may include a material different from that of the sacrificial layers 118. The sacrificial layers 118 and the first to third channel layers 141, 142, and 143 may include different semiconductor materials including at least one of, for example, silicon (Si), silicon germanium (SiGe), and germanium (Ge), and may include or might not include impurities. For example, the sacrificial layers 118 may include silicon germanium (SiGe), and the first to third channel layers 141, 142 and 143 may include silicon (Si).

The sacrificial layers 118 and the first to third channel layers 141, 142, and 143 may be formed by performing an epitaxial growth process from the semiconductor substrate 101. In some example embodiments of the present inventive concept, the number of the channel layers 141, 142 and 143, which are alternately stacked with the sacrificial layers 118, may be changed in various manners. A first isolation region IL1 and a second isolation region IL2 may be formed within the first channel layer 141, extending to a predetermined depth in the semiconductor substrate 101.

The first isolation region IL1 and the second isolation region IL2 may be formed by etching a region of the semiconductor substrate 101, excluding an active region 105 - where the first to fourth source/drain regions 150A to 150D and a channel structure 140 are disposed. A trench with a predetermined depth is then formed, and an insulating material may be stacked and may fill the trench. In this case, trenches may be formed such that an upper width of the first isolation region IL1 is greater than an upper width of the second isolation region IL2, and depths of the trenches may be different from each other depending on upper widths of the trenches.

The trench corresponding to the second isolation region IL2 with a narrower upper width may have a shallower depth than the trench corresponding to the first isolation region IL1. The first and second isolation regions IL1 and IL2 may be formed by applying an insulating material 102 that fills each trench.

Accordingly, an initial length ds of the first isolation region IL1 measured along a Z-direction may be greater than an initial length dt of the second isolation region IL2 measured along the Z-direction. The initial length ds of the first isolation region IL1 and the initial length dt of the second isolation region IL2 may be greater than the length d1 of each of the first isolation region IL1 and the second isolation region IL2 of FIG. 2, which is measured along the Z-direction.

The initial lengths ds and dt of the first and second isolation regions IL1 and IL2, lengths measured along the Z-direction, may be greater than the lengths d1 of each of the first isolation region IL1 and the second isolation region IL2 illustrated in FIG. 2. In this case, the widths of the first isolation region IL1 and the second isolation region IL2 may taper from upper surfaces to lower surfaces. The lower surfaces of the first isolation region IL1 and the second isolation region IL2 may be disposed at a level higher than a lower surface of the semiconductor substrate 101. Accordingly, the lower surfaces of the first isolation region IL1 and the second isolation region IL2 might not be exposed to the lower surface of the semiconductor substrate 101. A predetermined separation distance td may be maintained between the lower surface of the first isolation region IL1 and the lower surface of the semiconductor substrate 101. The initial length ts of the semiconductor substrate 101 may be greater than the predetermined separation distance td. The initial length ds of the first isolation region IL1 may be greater than the predetermined separation distance td.

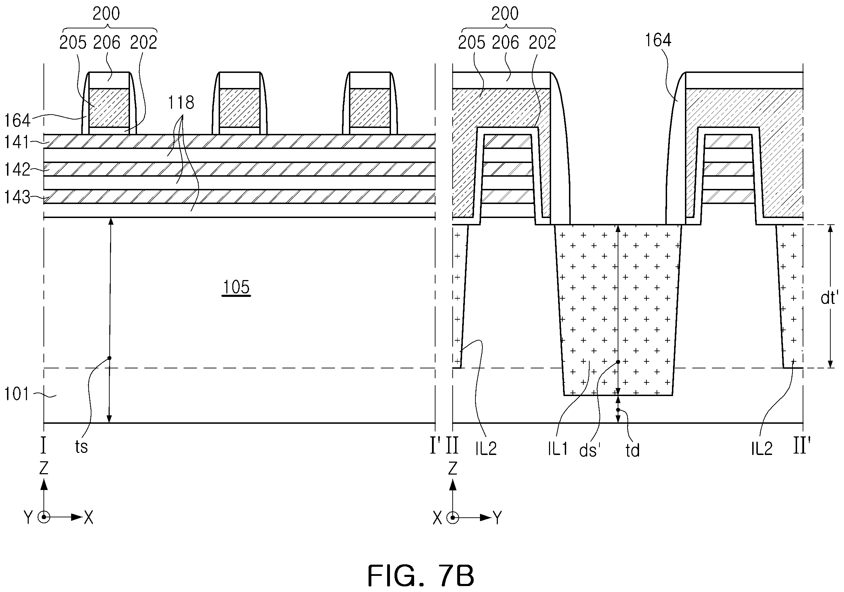

Referring to FIG. 7B, the first isolation region IL1 and the second isolation region IL2 may be etched to a level of the upper surface of the semiconductor substrate 101, such that upper surfaces of the first isolation region IL1 and the second isolation region IL2 may align with the upper surface of the semiconductor substrate 101. The initial lengths ds and dt of the first isolation region IL1 and the second isolation region IL2 may be reduced as illustrated in FIG. 7B, and may be referred to as reduced initial lengths ds' and dt'.

Subsequently, a portion of the sacrificial layers 118, the first to third channel layers 141, 142, and 143, and the substrate 101 may be removed and may form active structures. Sacrificial gate structures 200 and gate spacer layers 164 may be formed on the active structures.

The active structures may include sacrificial layers 118 and first to third channel layers 141, 142 and 143, stacked alternately with each other, and may further include active regions 105, which may protrude from the substrate 101 by removing a portion of the substrate 101. The active structures 105 may be formed to have a linear shape extending in one direction, for example, an X-direction, and may be spaced apart from each other along another direction (e.g. a Y-direction). The first isolation region IL1 and the second isolation region IL2 may be exposed between two active structures and may be spaced apart from each other. The active regions 105 may include different impurities in first and second regions R1 and R2. However, in some example embodiments of the present inventive concept, the active regions 105 might not include impurities.

The sacrificial gate structures 200 may be sacrificial structures formed in regions in which the gate dielectric layers 162 and the gate electrodes 165 are disposed on the channel structures 140 through a subsequent process, as illustrated in FIG. 2. The sacrificial gate structures 200 may have a linear shape extending along a single direction while intersecting the active structures. For example, the sacrificial gate structures 200 may extend along the Y-direction and may cut the first isolation region IL1 between the first and second regions R1 and R2.

Each of the sacrificial gate structures 200 may include first and second sacrificial gate layers 202 and 205, sequentially stacked, and a mask pattern layer 206. The first and second sacrificial gate layers 202 and 205 may be patterned using a mask pattern layer 206. The first and second sacrificial gate layers 202 and 205 may be an insulating layer and a conductive layer, respectively, but the present inventive concept is not necessarily limited thereto, and the first and second sacrificial gate layers 202 and 205 may be formed as a single layer. For example, the first sacrificial gate layer 202 may include silicon oxide, and the second sacrificial gate layer 205 may include polysilicon. The mask pattern layer 206 may include silicon oxide and/or silicon nitride.

The gate spacer layers 164 may be formed on both sidewalls of the sacrificial gate structures 200. The gate spacer layers 164 may be formed of a low-κ material, and may include at least one of SiO, SiN, SiCN, SiOC, SiON, and SiOCN. Accordingly, the gate spacer layers 164 may be disposed such that lower surfaces thereof are in contact with the first isolation region IL1.

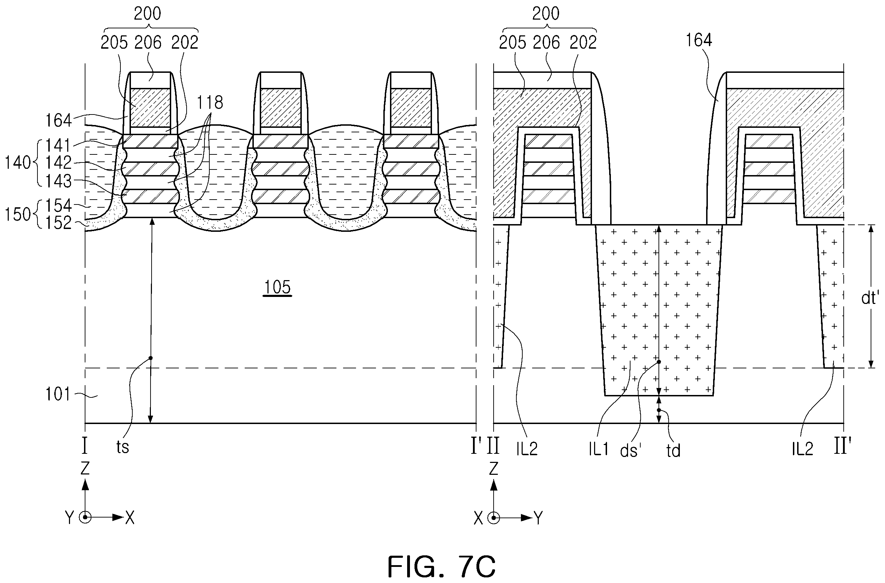

Referring to FIG. 7C, recess regions may be formed by partially removing the sacrificial layers 118 and the first to third channel layers 141, 142, and 143, which are exposed by the sacrificial gate structures 200.

First, portions of the exposed sacrificial layers 118 and first to third channel layers 141, 142, and 143 may be removed using the sacrificial gate structures 200 and the gate spacer layers 164 as masks, and the recess regions may be formed by partially removing the active regions 105. Accordingly, the first to third channel layers 141, 142 and 143 may form the channel structures 140 having a limited length along the X-direction.

The active regions 105, exposed through the recess regions, may be further removed to form extended recess regions, and may form first to fourth source/drain regions 150A, 150B, 150C, and 150D.

The first to fourth source/drain regions 150A, 150B, 150C, and 150D may be grown and formed from side surfaces of the channel structures 140 and the active regions 105 using a selective epitaxial process. The first and second source/drain regions 150A and 150B and the third and fourth source/drain regions 150C and 150D may be formed using different processes, and may have different compositions. The first to fourth source/drain regions 150A, 150B, 150C, and 150D may include impurities by in-situ doping. Each of the first to fourth source/drain regions 150A, 150B, 150C, and 150D may include first and second epitaxial layers 152 and 154. The first and second epitaxial layers 152 and 154 may include non-silicon elements having different concentrations.

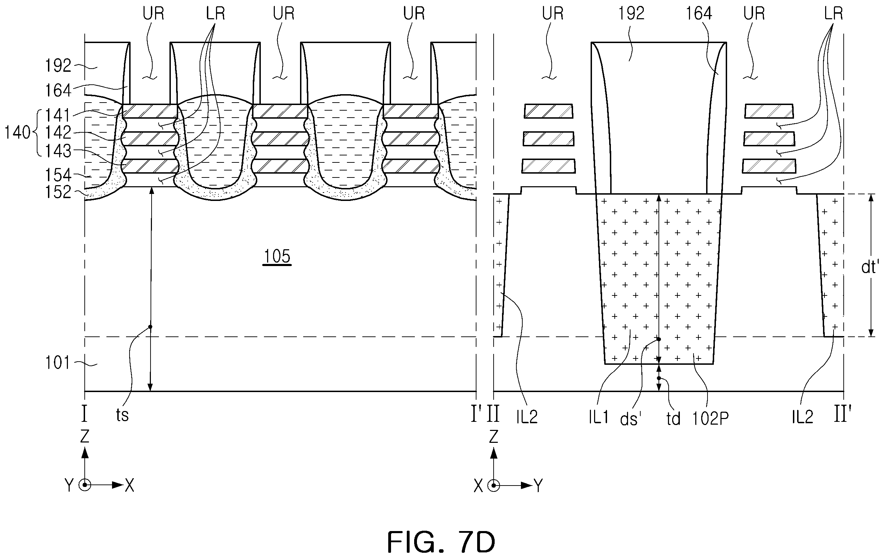

Referring to FIG. 7D, a first interlayer insulating layer 192 may be deposited, and the sacrificial layers 118 and the sacrificial gate structure 200 may be removed.

The first interlayer insulating layer 192 may be formed by forming an insulating film covering the sacrificial gate structure 200, the first to fourth source/drain regions 150A, 150B, 150C, and 150D, and the first isolation region IL1, and performing a planarization process.

The sacrificial layers 118 and the sacrificial gate structure 200 may be selectively removed with respect to the gate spacer layers 164, the first interlayer insulating layer 192, the first to fourth source/drain regions 150A, 150B, 150C, and 150D, and the channel structures 140. First, the sacrificial gate structure 200 may be removed to form an upper gap region UR. Then, the sacrificial layers 118, exposed through the upper gap region UR, may be removed to form lower gap regions LR. For example, when the sacrificial layers 118 include silicon germanium (SiGe), and the channel structures 140 include silicon (Si), the sacrificial layers 118 may be selectively removed by performing a wet etching process.

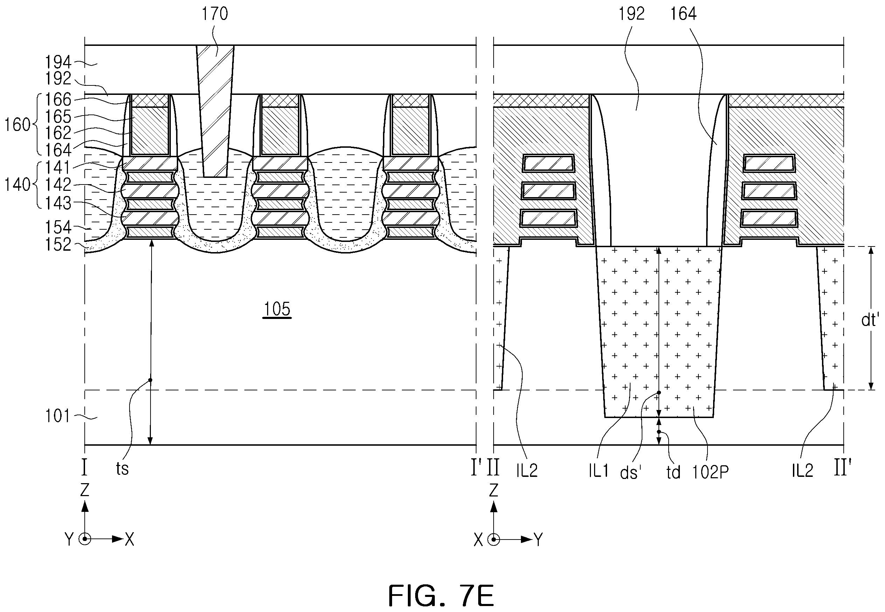

Referring to FIG. 7E, the gate dielectric layers 162 and the gate electrode 165 may form gate structures 160, a second interlayer insulating layer 194, and front contact plugs 170.

The gate dielectric layers 162 and the gate electrode 165 may fill the upper gap regions UR and the lower gap regions LR. The gate dielectric layers 162 may conformally cover internal surfaces of the upper gap regions UR and the lower gap regions LR. After the gate electrodes 165 entirely fill the upper gap regions UR and the lower gap regions LR, the gate electrodes 165 may be removed from upper portions thereof to a predetermined depth in the upper gap regions UR, together with the gate dielectric layers 162 and the gate spacer layers 164, and gate capping layers 166 may be formed.

The second interlayer insulating layer 194 may be formed on the gate structures 160. After the second interlayer insulating layer 194 is formed, the front contact plugs 170, which passes through the second interlayer insulating layer 194 and the first interlayer insulating layer 192, may be formed.

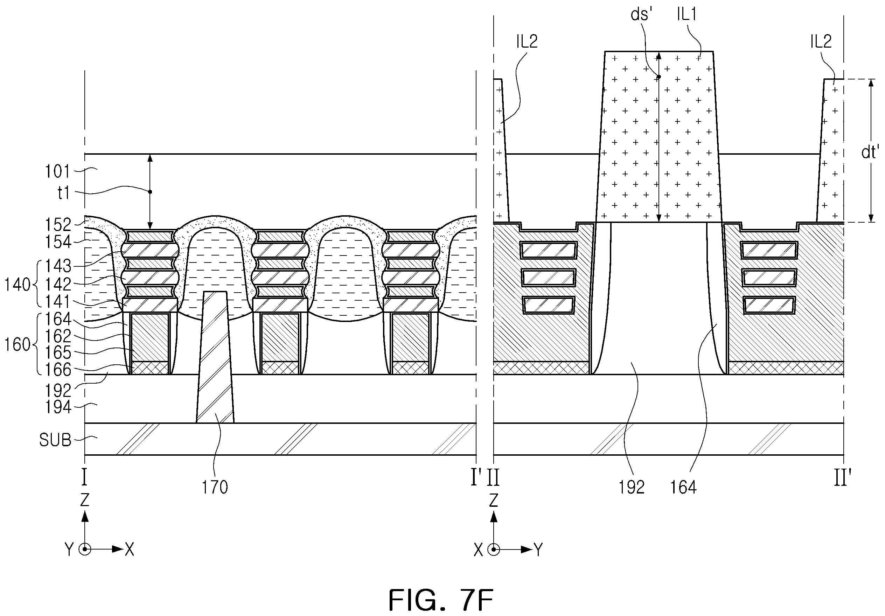

Referring to FIG. 7F, the semiconductor substrate 101 may be partially removed.

First, in order to perform a process on a lower surface of the substrate 101, a carrier substrate SUB may be formed on the second interlayer insulating layer 194, and the entire structure may be inverted to perform the following processes.

The semiconductor substrate 101 may be thinned to have a first thickness t1 by performing dry etching from the lower surface of the semiconductor substrate 101. The first isolation region IL1 having a lower surface spaced apart from the lower surface of the semiconductor substrate 101 by a predetermined separation distance td, and the second isolation region IL2 having a lower surface on a level higher than that of the lower surface of the first isolation region IL1, may remain unetched. The first and second isolation regions IL1 and IL2 may maintain the reduced initial lengths ds' and dt' due to selective etching of the semiconductor substrate 101.

Accordingly, the lower surfaces of the first and second isolation regions IL1 and IL2 may protrude upwardly from the lower surface of the thinned semiconductor substrate 101 during a process, and protruding lengths of the first and second isolation regions IL1 and IL2 may be different from each other. Residual portions may be formed between side surfaces of the first and second isolation regions IL1 and IL2 and the lower surface of the semiconductor substrate 101 by selective dry etching of the semiconductor substrate 101, but the present inventive concept is not necessarily limited thereto.

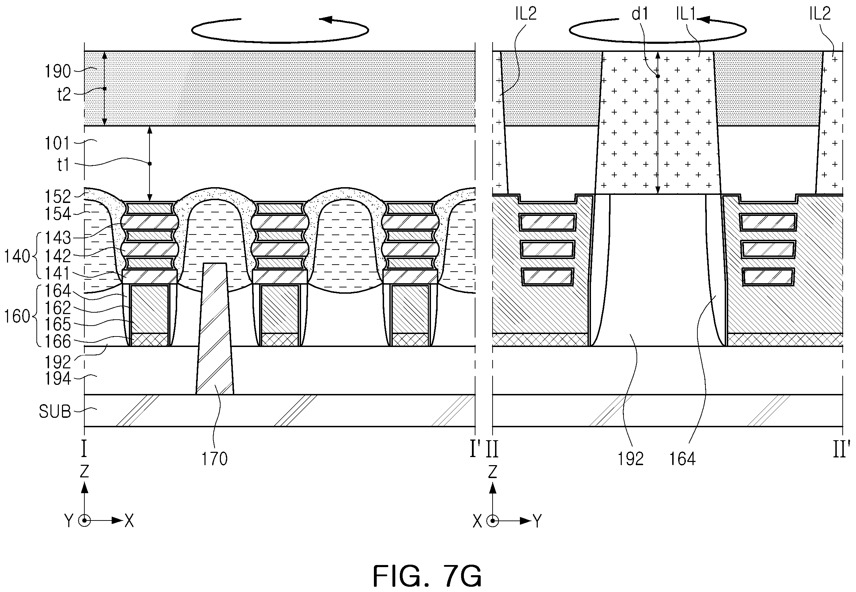

Referring to FIG. 7G, the substrate insulating layer 190 may be formed on the exposed lower surface of the semiconductor substrate 101, and may be thinned to have a second thickness t2.

For example, the substrate insulating layer 190 having a sufficient thickness may be deposited to cover the lower surfaces of the protruding first and second isolation regions IL1 and IL2. The substrate insulating layer 190 may be formed by stacking silicon nitride, but the present inventive concept is not necessarily limited thereto. Subsequently, the substrate insulating layer 190 may be thinned to have the second thickness t2 illustrated in FIG. 2 by performing planarization, and the lengths of the first and second isolation regions IL1 and IL2 may also decrease from etching. Accordingly, the lower surfaces of the first and second isolation regions IL1 and IL2 may be exposed at a lower surface of the substrate insulating layer 190.

In this case, thinning may be performed using a chemical mechanical polishing (CMP), and accordingly, the first and second isolation regions IL1 and IL2 may have a first length d1 from the upper surface of the semiconductor substrate 101. The first length d1 may be equal to or similar to a sum of the first thickness t1 of the semiconductor substrate 101 and the second thickness t2 of the substrate insulating layer 190.

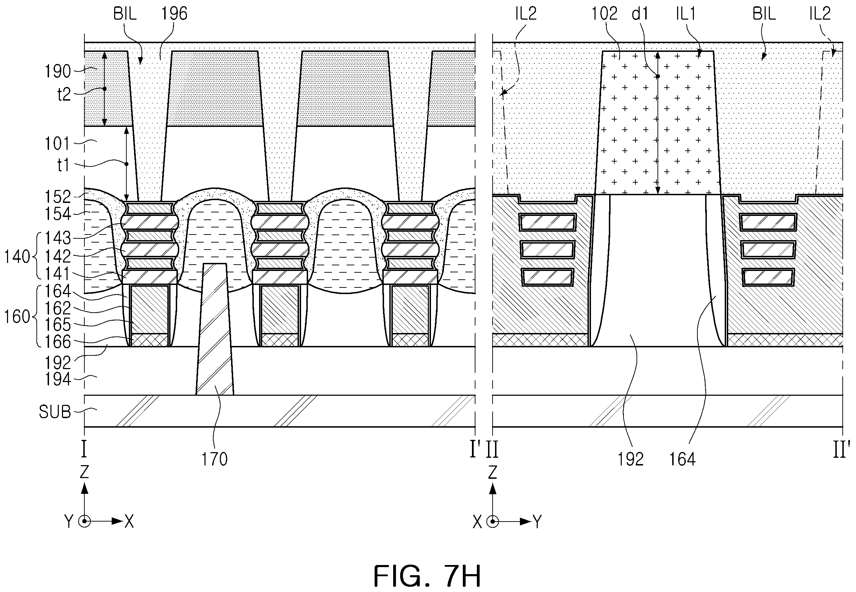

Referring to FIG. 7H, backside isolation regions BIL may be formed.

First, trenches, extending from a lower surface of the substrate insulating layer 190 to a lower surface of the gate structure 160, may be formed to be respectively aligned with the gate structures 160. At least a portion of the trenches may overlap the gate structure 160 along the Z-direction, and may be formed to have a linear shape. The trenches for the backside isolation regions BIL may cross the second isolation region IL2 along the Y-direction. The insulating material 196 may be over-deposited to fill respective trenches and cover the lower surface of the substrate insulating layer 190. The insulating material 196 may be silicon oxide or silicon nitride, but the present inventive concept is not necessarily limited thereto.

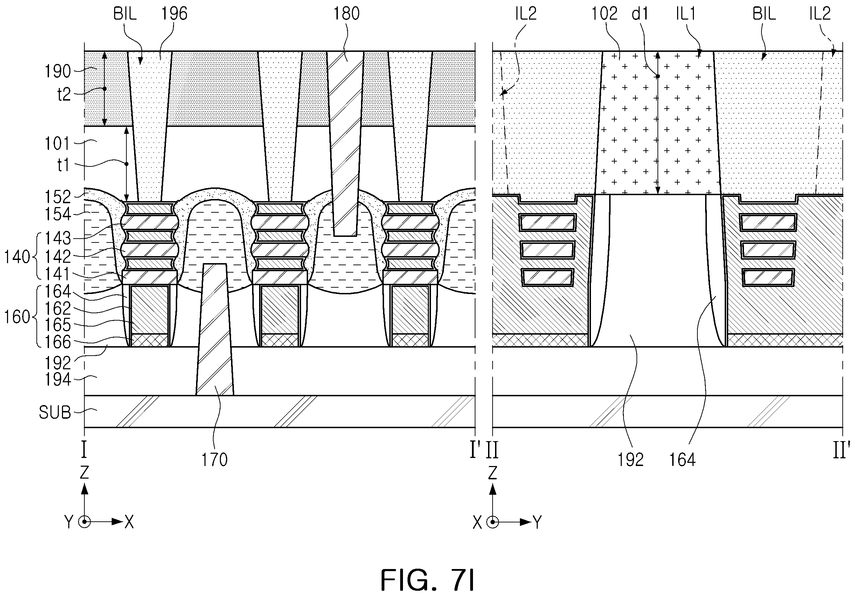

Referring to FIG. 7I, the backside contact plugs 180 may be formed.

The over-deposited insulating material 196 may be removed using planarization and expose the lower surface of the substrate insulating layer 190, thereby exposing the lower surfaces of the first and second isolation regions **IL1** and IL2, and the backside isolation regions BIL. Referring to FIG. 7I, contact holes may be formed reaching toward the second and fourth source/drain regions 150B and 150D while exposing the lower surface of the substrate insulating layer 190, as described above. When the contact holes are formed, the backside contact plugs 180 may be formed by forming conductive layers, filling the contact holes.

Subsequently, referring to FIG. 2, a third interlayer insulating layer 198 may be formed, and a portion of the third interlayer insulating layer 198 may be removed to form backside power structures 185 connected to the backside contact plugs 180. Accordingly, the semiconductor device 100 of FIGS. 1 and 2 may be manufactured.

According to example embodiments of the present inventive concept, when a backside contact plug 180 is formed according to transistor properties, a portion of a semiconductor substrate 101 may remain, and a lower insulating layer may be formed to optimize a process, thereby providing a semiconductor device 100 having improved electrical properties and increased process yield.

Embodiments are set out in the following Clauses:
Clause 1. A semiconductor device, comprising:
   a substrate including a first region and a second region spaced apart from each other along a first direction, wherein the substrate includes an upper surface and a lower surface;
   a substrate insulating layer disposed on the lower surface of the substrate;
   a first isolation region passing through the substrate between the first region and the second region, the first isolation region extending towards the substrate insulating layer;
   gate electrodes disposed in the first region and the second region, on the upper surface of the substrate;
   a plurality of channel layers spaced apart from each other along a second direction, which is perpendicular to the upper surface of the substrate, and surrounded by the gate electrodes, wherein the plurality of channel layers are disposed on the first and second regions;
   source/drain regions disposed at opposite sides of the gate electrodes, wherein the source/drain regions are connected to the plurality of channel layers;
   a backside contact plug extending along the second direction from a lower surface of the substrate insulating layer to at least one of the source/drain regions, wherein the backside contact plug is connected to the source/drain regions; and
   a backside isolation region passing through the substrate and the substrate insulating layer, and the backside isolation region separating the substrate.
Clause 2. The semiconductor device of Clause 1, wherein a lower surface of the backside isolation region, a lower surface of the backside contact plug, and the lower surface of the substrate insulating layer are coplanar with each other.
Clause 3. The semiconductor device of Clause 1 or Clause 2, wherein the lower surface of the substrate insulating layer and a lower surface of the first isolation region are coplanar with each other.
Clause 4. The semiconductor device of any preceding Clause, wherein
   the substrate has a first thickness,
   the substrate insulating layer has a second thickness, and
   the second thickness is equal to or greater than the first thickness.
Clause 5. The semiconductor device of Clause 4, wherein the second thickness is 1 to 1.2 times the first thickness.
Clause 6. The semiconductor device of Clause 4 or Clause 5, wherein the backside isolation region has a vertical length, which is greater than the first thickness of the substrate.
Clause 7. The semiconductor device of any of Clauses 4-6, wherein the first isolation region has a vertical length, which is greater than the first thickness of the substrate.
Clause 8. The semiconductor device of any preceding Clause, wherein the backside contact plug has a vertical length, which is greater than the vertical length of the first isolation region and the vertical length of the backside isolation region.
Clause 9. The semiconductor device of any preceding Clause, wherein the backside isolation region has a linear shape, with at least a portion of the backside isolation region overlapping the gate electrodes along the second direction.
Clause 10. The semiconductor device of any preceding Clause, wherein a width of the first isolation region is greater than a length of the gate electrodes measured along a third direction, and the third direction is perpendicular to the first direction.
Clause 11. The semiconductor device of any preceding Clause, further comprising:
   a second isolation region disposed in the first region and the second regions, wherein the second isolation region extends along a third direction, which is perpendicular to the first direction, between the source/drain regions to separate the substrate.
Clause 12. The semiconductor device of Clause 11, wherein a width of the second isolation region is less than a width of the first isolation region.
Clause 13. The semiconductor device of Clause 12, wherein a length of the second isolation region is equal to a length of the first isolation region.
Clause 14. The semiconductor device of any preceding Clause, wherein the source/drain regions include:
   a first epitaxial layer covering side surfaces of the plurality of channel layers, and the first epitaxial layer has a first impurity concentration; and
   a second epitaxial layer disposed on the first epitaxial layer, and the second epitaxial layer has a second impurity concentration, which is higher than the first impurity concentration.
Clause 15. The semiconductor device of Clause 14, wherein the backside contact plug passes through the first epitaxial layer, and the backside contact plug includes an upper end that contacts the second epitaxial layer.
Clause 16. The semiconductor device of any preceding Clause, wherein the backside contact plug includes:
   a conductive layer passing through the substrate insulating layer and the substrate, and the conductive layer extends into the source/drain regions; and
   a metal-semiconductor compound layer disposed between the conductive layer and the source/drain regions and between the conductive layer and the substrate, and the metal-semiconductor compound layer is an upper end of the backside contact plug.
Clause 17. The semiconductor device of any preceding Clause, wherein the first region is an nFET region, and the second region is a pFET region.
Clause 18. A semiconductor device, comprising:
   a semiconductor substrate having an upper surface and a lower surface;
   a substrate insulating layer disposed on the lower surface of the semiconductor substrate;
   gate electrodes disposed on the upper surface of the semiconductor substrate and extending along a first direction, and the gate electrodes are spaced apart from each other;
   a plurality of channel layers spaced apart from each other along a second direction, which is perpendicular to the upper surface of the semiconductor substrate, and the plurality of channel layers are surrounded by the gate electrodes disposed on the upper surface of the semiconductor substrate;
   source/drain regions disposed at opposite sides of the gate electrodes, and the source/drain regions including first and second source/drain regions spaced apart from each other; and
   a backside contact plug extending along the second direction from a lower surface of the substrate insulating layer, and the backside contact plug recesses from at least one of the first and second source/drain regions,
   wherein a thickness of the semiconductor substrate is equal to or less than a thickness of the substrate insulating layer.
Clause 19. The semiconductor device of Clause 18, further comprising:
   a backside isolation region extending from the lower surface of the semiconductor substrate insulating layer towards the upper surface of the semiconductor substrate and electrically separate the substrate,
   wherein a lower surface of the backside isolation region and a lower surface of the backside contact plug are coplanar with each other.
Clause 20. A semiconductor device, comprising:
   a semiconductor substrate having an upper surface and a lower surface;
   a substrate insulating layer disposed on the lower surface of the semiconductor substrate;
   gate electrodes disposed on the upper surface of the semiconductor substrate and extending along a first direction, and the gate electrodes are spaced apart from each other;
   source/drain regions disposed at opposite sides of the gate electrodes, and the source/drain regions include first and second source/drain regions spaced apart from each other;
   an upper insulating layer disposed on the source/drain regions;
   a front contact plug passing through the upper insulating layer, and the front contact plug is connected to at least one of the first and second source/drain regions;
   a backside contact plug extending along a second direction, which is perpendicular to an upper surface of the semiconductor substrate, from a lower surface of the substrate insulating layer, and the backside contact plug is connected to at least one of the first and second source/drain regions;
   a backside power structure connected to the backside contact plug and configured to transfer power; and
   a backside isolation region passing through the semiconductor substrate and the substrate insulating layer,
   wherein the backside isolation region separates the semiconductor substrate, and
   wherein a lower surface of the backside isolation region, a lower surface of the backside contact plug, and the lower surface of the substrate insulating layer are coplanar with each other.

While example embodiments have been shown and described above, it will be apparent to those skilled in the art that modifications and variations could be made without departing from the scope of the present inventive concept as defined.

## Claims

1. A semiconductor device, comprising:
a substrate including a first region and a second region spaced apart from each other along a first direction, wherein the substrate includes an upper surface and a lower surface;
a substrate insulating layer disposed on the lower surface of the substrate;
a first isolation region passing through the substrate between the first region and the second region, the first isolation region extending towards the substrate insulating layer;
gate electrodes disposed in the first region and the second region, on the upper surface of the substrate;
a plurality of channel layers spaced apart from each other along a second direction, which is perpendicular to the upper surface of the substrate, and surrounded by the gate electrodes, wherein the plurality of channel layers are disposed on the first and second regions;
source/drain regions disposed at opposite sides of the gate electrodes, wherein the source/drain regions are connected to the plurality of channel layers;
a backside contact plug extending along the second direction from a lower surface of the substrate insulating layer to at least one of the source/drain regions, wherein the backside contact plug is connected to the source/drain regions; and
a backside isolation region passing through the substrate and the substrate insulating layer, and the backside isolation region separating the substrate.

2. The semiconductor device of claim 1, wherein a lower surface of the backside isolation region, a lower surface of the backside contact plug, and the lower surface of the substrate insulating layer are coplanar with each other.

3. The semiconductor device of claim 1 or claim 2, wherein the lower surface of the substrate insulating layer and a lower surface of the first isolation region are coplanar with each other.

4. The semiconductor device of any preceding claim, wherein
the substrate has a first thickness,
the substrate insulating layer has a second thickness, and
the second thickness is greater than or equal to the first thickness.

5. The semiconductor device of claim 4, wherein the second thickness is 1 to 1.2 times the first thickness.

6. The semiconductor device of claim 4 or claim 5, wherein the backside isolation region has a vertical length, which is greater than the first thickness of the substrate.

7. The semiconductor device of any of claims 4-6, wherein the first isolation region has a vertical length, which is greater than the first thickness of the substrate.

8. The semiconductor device of any preceding claim, wherein the backside contact plug has a vertical length, which is greater than the vertical length of the first isolation region and the vertical length of the backside isolation region.

9. The semiconductor device of any preceding claim, wherein the backside isolation region has a linear shape, with at least a portion of the backside isolation region overlapping the gate electrodes along the second direction.

10. The semiconductor device of any preceding claim, further comprising:
a second isolation region disposed in the first region and the second region, wherein the second isolation region extends along a third direction, which is perpendicular to the first direction, between the source/drain regions to separate the substrate.

11. The semiconductor device of claim 10, wherein a width of the second isolation region is less than a width of the first isolation region.

12. The semiconductor device of claim 11, wherein a length of the second isolation region is equal to a length of the first isolation region.

13. The semiconductor device of any preceding claim, wherein the source/drain regions include:
a first epitaxial layer covering side surfaces of the plurality of channel layers, and the first epitaxial layer has a first impurity concentration; and
a second epitaxial layer disposed on the first epitaxial layer, and the second epitaxial layer has a second impurity concentration, which is higher than the first impurity concentration.

14. The semiconductor device of claim 13, wherein the backside contact plug passes through the first epitaxial layer, and the backside contact plug includes an upper end that contacts the second epitaxial layer.

15. The semiconductor device of any preceding claim, wherein the backside contact plug includes:
a conductive layer passing through the substrate insulating layer and the substrate, and the conductive layer extends into the source/drain regions; and
a metal-semiconductor compound layer disposed between the conductive layer and the source/drain regions and between the conductive layer and the substrate, and the metal-semiconductor compound layer is an upper end of the backside contact plug.
